(19) Europäisches Patentamt
European Patent Office
Office européen des brevets

(11) **EP 3 799 328 B1**

(12) **FASCICULE DE BREVET EUROPEEN**

(45) Date de publication et mention
de la délivrance du brevet:
**08.11.2023 Bulletin 2023/45**

(21) Numéro de dépôt: **20196624.9**

(22) Date de dépôt: **17.09.2020**

(51) Classification Internationale des Brevets (IPC):
**H04B 7/06** *(2006.01)*    **H04B 1/04** *(2006.01)*
**H03F 1/02** *(2006.01)*    **H01Q 3/36** *(2006.01)*
**H03F 3/21** *(2006.01)*    **H03F 3/60** *(2006.01)*
**H01Q 3/28** *(2006.01)*

(52) Classification Coopérative des Brevets (CPC):
**H04B 7/0617; H01Q 3/28; H01Q 3/36;
H03F 1/0211; H03F 1/0294; H03F 3/211;
H03F 3/245; H03F 3/602; H04B 1/0458;
H04B 1/0483**

(54) **PROCÉDÉ DE CONDITIONNEMENT DE SIGNAUX ET DISPOSITIF ASSOCIÉ**

VERFAHREN ZUR SIGNALVERARBEITUNG UND ENTSPRECHENDE VORRICHTUNG

METHOD FOR SIGNAL CONDITIONING AND ASSOCIATED DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.09.2019 FR 1910813**

(43) Date de publication de la demande:
**31.03.2021 Bulletin 2021/13**

(73) Titulaire: **STMICROELECTRONICS SA
92120 Montrouge (FR)**

(72) Inventeurs:
- **KNOPIK, Vincent
38830 CRÊTS EN BELLEDONNE (FR)**
- **FOREST, Jeremie
38190 VILLARD BONNOT (FR)**

(74) Mandataire: **Casalonga
Casalonga & Partners
Bayerstraße 71/73
80335 München (DE)**

(56) Documents cités:
**EP-A1- 2 456 090    US-A1- 2016 164 466
US-A1- 2019 158 047    US-B1- 9 137 067**

**Description**

Des modes de mise en oeuvre et de réalisation de l'invention concernent les dispositifs électroniques dédiés aux transmissions d'information, en particulier pour les applications radiofréquences (« radio frequency » : RF en anglais) et plus particulièrement des dispositifs électroniques comprenant des coupleurs hybrides (« hybrid couplers » en anglais).

Généralement un dispositif électronique dédié à la transmission radio d'informations comprend une chaîne de transmission comportant plusieurs lignes de transmission reliées chacune à une antenne.

De tels dispositifs électroniques sont décrits dans les documents US 2016/164466 A1 et EP 2456090 A1.

Chaque ligne de transmission effectue notamment des opérations de filtrage spatial (« beamforming » en anglais) permettant de contrôler la phase et l'amplitude des signaux émis par chaque antenne du dispositif électronique pour créer des interférences constructives ou destructives entre les ondes électromagnétiques émises.

Généralement un signal destiné à être émis par une antenne transite à travers la ligne de transmission comprenant un premier amplificateur à gain variable relié à un déphaseur, un premier et un deuxième étages de couplage hybride fonctionnant respectivement en diviseur de puissance et en combineur de puissance, les deux étages comportant chacun deux entrées et deux sorties, chaque sortie du premier étage de couplage étant reliée à une entrée du deuxième étage de couplage par un deuxième amplificateur de puissance à gain variable.

Le déphaseur est relié à une première entrée du premier étage de couplage, la deuxième entrée étant reliée à une première résistance de ballast.

Une première sortie du deuxième étage est reliée à l'antenne, la deuxième sortie étant reliée à une deuxième résistance de ballast.

Cependant, chaque ligne de transmission consomme de la puissance électrique pour assurer le filtrage spatial, notamment le premier amplificateur de puissance et le déphaseur, la consommation de puissance électrique est proportionnelle au nombre d'antennes du dispositif (matrice d'antennes).

En outre, l'implantation de chaque ligne de transmission occupe de la place sur le silicium.

Il existe ainsi un besoin de proposer une solution technique permettant de diminuer la consommation des opérations de filtrage spatial réalisées par la chaîne de transmission tout en réduisant la place occupée par ladite chaîne sur le silicium.

Selon la revendication indépendante 1, il est proposé un procédé de conditionnement de signaux émis par au moins deux antennes à partir d'un signal d'entrée de puissance, les deux antennes étant reliées à un chemin de transmission comprenant un premier étage de couplage comportant un diviseur de puissance 90° et un deuxième étage de couplage comportant un combineur de puissance 90°, et des moyens d'amplification de puissance à gain variable, chaque étage de couplage comportant deux entrées et deux sorties, les deux entrées du premier étage de couplage recevant ledit signal d'entrée de puissance, chaque sortie du premier étage de couplage étant reliée à une entrée différente du deuxième étage de couplage par l'intermédiaire des moyens d'amplification de puissance à gain variable, chaque sortie du deuxième étage de couplage étant reliée à une antenne différente, le procédé comprenant la détermination des gains des moyens d'amplification en fonction des caractéristiques du signal d'entrée de puissance, des caractéristiques des signaux émis par les antennes, et des caractéristiques des étages de couplage.

Le conditionnement des signaux s'entend donc ici comme étant les étapes contribuant à l'élaboration des signaux émis par les antennes à partir d'un signal d'entrée de puissance.

Le couplage des deux entrées et sorties des premier et deuxième étages de couplage des chemins de transmission permettent de déphaser et amplifier les signaux émis par les antennes sans l'implémentation d'un déphaseur réduisant ainsi la consommation et l'encombrement sur le silicium des chemins de transmission, les coupleurs fonctionnant comme déphaseur, le déphasage étant piloté en ajustant les gains des moyens d'amplification.

Selon un mode de mise en oeuvre, les caractéristiques du signal d'entrée de puissance comprennent l'amplitude et le déphasage dudit signal, et les caractéristiques des signaux émis par les antennes comprennent l'amplitude et le déphasage des signaux émis par rapport à un signal de référence.

Le déphasage varie dans un intervalle de -35° à +35° par rapport au signal de référence.

Selon autre un mode de mise en oeuvre, les caractéristiques des étages de couplage comprennent un coefficient de perte de chaque étage de couplage.

Selon encore autre un mode de mise en oeuvre, le procédé comprend la détermination du gain de moyens de déphasage reliés à au moins une entrée du premier étage de couplage en fonction des caractéristiques du signal d'entrée de puissance, des caractéristiques des signaux émis par les antennes, et des caractéristiques des étages de couplage.

L'ajout des moyens de déphasage permet d'étendre le déphasage sur un intervalle plus large que celui défini entre -35° à +35°.

Selon encore autre un mode de mise en oeuvre, le procédé comprend un premier réglage des gains identiques du premier chemin de transmission relié aux deux antennes émettant des signaux identiques formant un signal de référence et au moins un deuxième réglage des gains d'au moins un deuxième chemin de transmission relié à deux antennes émettant chacun un signal déphasé par rapport au signal de référence.

Selon la revendication indépendante 6, il est proposé un dispositif électronique, comprenant au moins deux antennes destinées à émettre des signaux, et au moins un chemin de transmission, le chemin de transmission comportant un premier étage de couplage comportant un diviseur de puissance 90° et un deuxième étage de couplage comportant un combineur de puissance 90°, et des moyens d'amplification de puissance à gain variable, chaque étage de couplage comportant deux entrées et deux sorties, les deux entrées du premier étage de couplage étant destinées à recevoir un signal d'entrée de puissance, chaque sortie du premier étage de couplage étant reliée à une entrée différente du deuxième étage de couplage par l'intermédiaire des moyens d'amplification de puissance à gain variable, chaque sortie du deuxième étage de couplage étant reliée à une antenne différente, le dispositif électronique comportant des moyens de commande configurés pour piloter les gains des moyens d'amplification de puissance à gain variable en fonction des caractéristiques du signal d'entrée de puissance, des caractéristiques des signaux émis par les antennes et des caractéristiques des étages de couplage.

Selon un mode de réalisation, les caractéristiques du signal d'entrée de puissance comprennent l'amplitude et le déphasage dudit signal, et les caractéristiques des signaux émis par les antennes comprennent l'amplitude et le déphasage des signaux émis par rapport à un signal de référence.

Selon un autre mode de réalisation, les caractéristiques des étages de couplage comprennent un coefficient de perte de chaque étage de couplage.

Selon encore un autre mode de réalisation, au moins une entrée du premier étage de couplage comprend des moyens de déphasage pilotés par les moyens de commande.

Selon encore un autre mode de réalisation, les moyens d'amplification de puissance à gain variable comprennent deux moyens d'amplification passifs ou actifs reliant, chaque moyen reliant une sortie du premier étage de couplage à une entrée différente du deuxième étage de couplage.

Selon encore un autre mode de réalisation, les moyens d'amplification de puissance à gain variable passifs comprennent au moins un réseau de transistors.

Selon encore un autre mode de réalisation, les moyens d'amplification de puissance à gain variable actifs comprennent au moins un amplificateur de puissance à gain variable.

Selon encore un autre aspect, il est proposé un appareil de communication sans fil incorporant au moins un dispositif tel que défini ci-avant.

D'autres avantages et caractéristiques de l'invention apparaîtront à l'examen de la description détaillée de modes de mise en oeuvre et de réalisation, nullement limitatifs, et des dessins annexés sur lesquels :

[Fig 1]
[Fig 2]
[Fig 3]
[Fig 4]
[Fig 5]

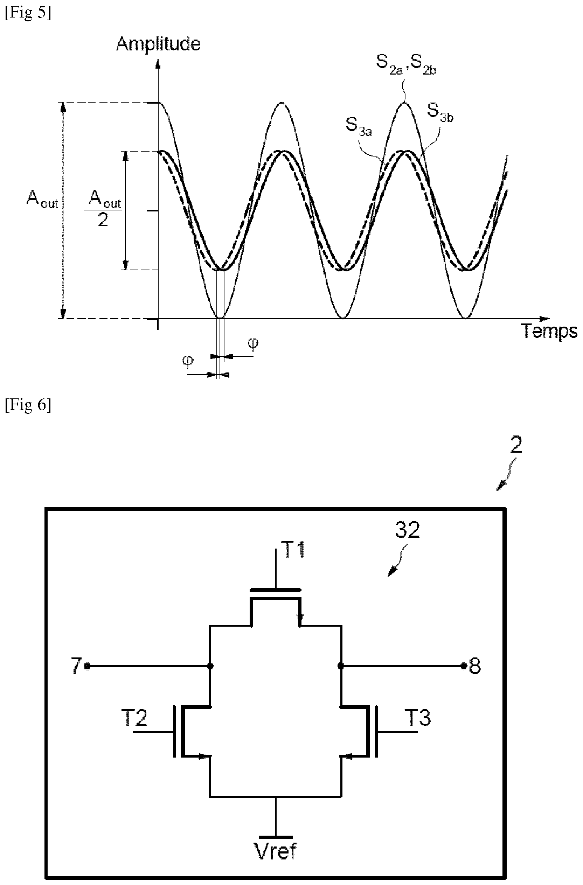

[Fig 6], et
[Fig 7]
illustrent schématiquement des modes de mise en oeuvre et de réalisation de l'invention.

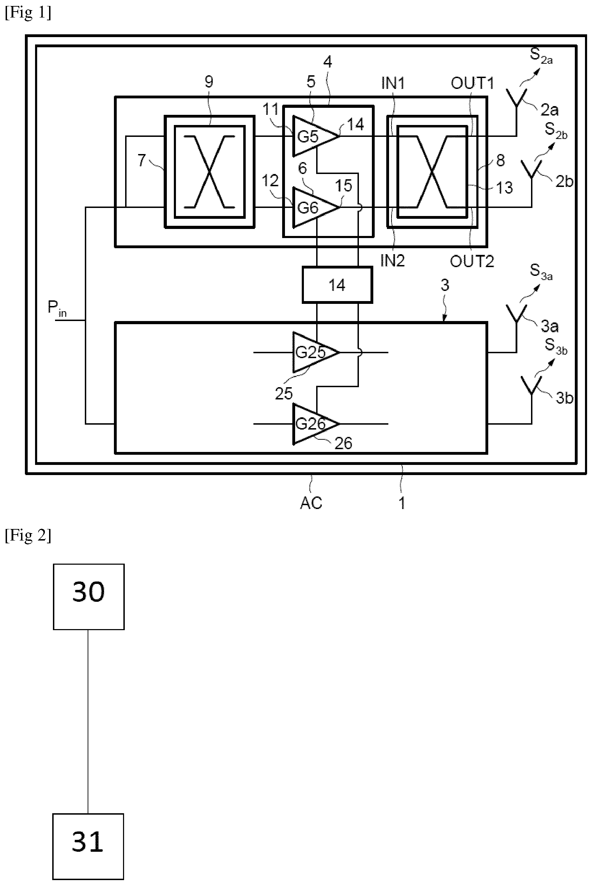

La référence AC illustrée sur la figure 1 représente un appareil de communication sans fil, ici par exemple un téléphone portable cellulaire comportant au moins un dispositif électronique 1, ici par exemple un dispositif 1 radiofréquence millimétrique réalisé de façon intégré.

Le dispositif 1 comporte deux chemins de transmission 2 et 3 d'architecture identique.

Un premier chemin de transmission 2 est couplé à deux antennes 2a et 2b, et le deuxième chemin de transmission 3 est couplé à deux antennes 3a et 3b.

Le dispositif 1 comporte une matrice de deux fois deux antennes.

Bien entendu, le dispositif 1 peut comporter un ou plus de deux chemins de transmission couplés chacun à deux antennes.

Les chemins de transmission 2 et 3 peuvent être configurés pour émettre un signal RF ou recevoir un signal RF via les antennes 2a, 2b, 3a, 3b.

A des fins de simplification et de clarté, comme les chemins de transmission 2 et 3 sont identiques, seul le premier chemin de transmission 2 est détaillé dans ce qui suit.

Le premier chemin de transmission 2 comprend des moyens d'amplification de puissance à gain variable comprenant un étage amplificateur 4 comportant des éléments actifs par exemple un premier amplificateur de puissance 5 à gain variable G5 et un deuxième amplificateur de puissance 6 à gain variable G6 couplés en parallèle entre un premier étage de couplage 7 et un deuxième étage de couplage 8.

Le premier étage de couplage 7 comprend un premier coupleur en quadrature hybride, ici par exemple un diviseur de puissance 90° référencé 9 dont une première entrée et une deuxième entrée sont destinées à recevoir un signal d'entrée de puissance Pin, dont une première sortie est couplée à l'entrée 11 du premier amplificateur 5, et dont une deuxième sortie est couplée à l'entrée 12 du deuxième amplificateur 6.

Dans un cas idéal, la puissance du signal d'entrée Pin est distribuée également, via le diviseur de puissance 9, entre les première et deuxième sorties du diviseur de puissance 9, avec un déphasage nul entre ces première et deuxième sorties.

Généralement le premier étage de couplage 7 présente un premier coefficient de perte η1 égal par exemple à 1dB.

Le deuxième étage de couplage 8 comprend un deuxième coupleur en quadrature hybride, ici par exemple un combineur de puissance 90° référencé 13 dont une première borne d'entrée IN1 est couplée à la sortie 14 du premier amplificateur 5, dont une deuxième borne d'entrée IN2 est couplée à la sortie 15 du deuxième amplificateur 6, dont une première borne de sortie OUT1 est couplée à l'antenne 2a et dont une deuxième borne de sortie OUT2 est couplée à l'antenne 2b.

Le dispositif 1 comprend en outre des moyens de commande 14 configurés pour piloter le gain de chaque amplificateur de puissance 5, 6 en fonction des caractéristiques du signal d'entrée de puissance Pin, des caractéristiques des signaux S2a, S2b émis par les antennes 2a et 2b, et des caractéristiques des étages de couplage 7 et 8.

Les moyens de commande 14 comportent par exemple une unité de traitement configurée pour piloter le gain de chaque amplificateur de puissance 5, 6 en fonction des caractéristiques du signal d'entrée de puissance Pin, des caractéristiques des signaux S2a, S2b émis par les antennes 2a et 2b, et des caractéristiques des étages de couplage 7 et 8, et réalisée par exemple à partir d'un microcontrôleur.

Dans un cas idéal, la puissance transmise à chaque antenne 2a et 2b est égale à la combinaison des puissances des signaux de sortie des amplificateurs 5 et 6, déphasé ou pas déphasé par rapport au signal d'entrée Pin selon que les gains des amplificateurs 5 et 6 sont égaux ou non tel qu'illustré dans ce qui suit.

Généralement le deuxième étage de couplage 8 présente un deuxième coefficient de perte η2 égal par exemple au premier coefficient de perte η1.

De manière analogue au premier chemin de transmission 2, les moyens d'amplification de puissance du deuxième chemin de transmission 3 comporte un premier amplificateur de puissance 25 de gain variable G25 et un deuxième amplificateur de puissance 26 de gain G26.

Bien entendu, les moyens de commande 14 sont en outre configurés pour piloter le premier amplificateur de puissance 25 de gain variable G25 et le deuxième amplificateur de puissance 26 de gain G26 du deuxième chemin de transmission 3, en fonction des caractéristiques du signal d'entrée de puissance Pin, des caractéristiques des signaux S3a, S3b émis par les antennes 3a et 3b, et des caractéristiques des étages de couplage 7 et 8 du deuxième chemin de transmission 3.

A présent un exemple de mode de mise en oeuvre du dispositif 1 est décrit à la figure 2.

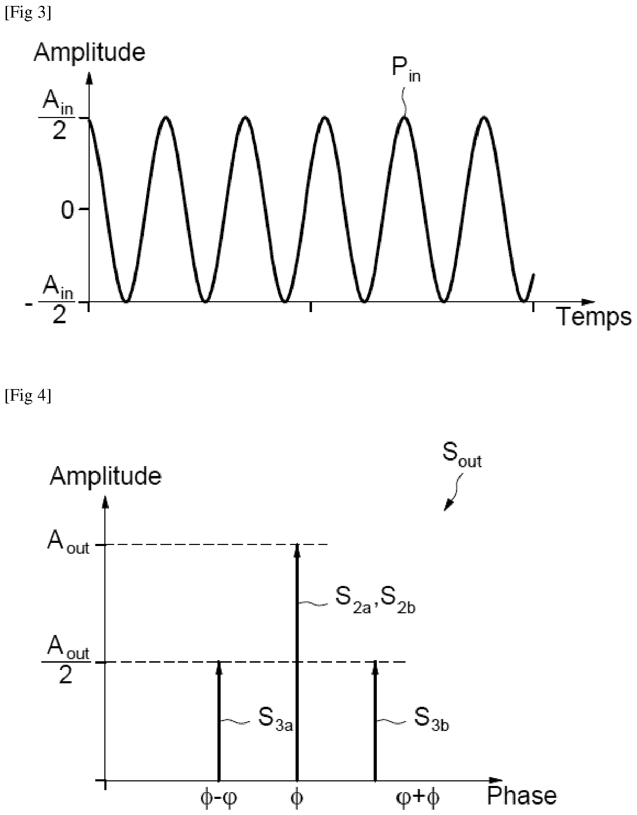

On suppose que le signal d'entrée de puissance Pin est par exemple un signal sinusoïdal d'amplitude $A_{in}$ centré sur zéro de fréquence Fc comme représenté à la figure 3.

On suppose en outre que le dispositif 1 émet par exemple un signal de sortie $S_{out}$ de fréquence Fc à partir du signal d'entrée de puissance Pin, la figure 4 représentant le spectre de raies du signal de sortie $S_{out}$ en fonction de la phase.

Le signal $S_{out}$ comporte un fondamental d'amplitude $A_{out}$ avec une phase Φ et deux raies d'amplitude $A_{out}/2$ avec respectivement une phase Φ-φ et Φ+φ, φ étant un déphasage prédéterminé par rapport à la fréquence du signal Pin. On suppose que les antennes 2a et 2b émettent le fondamental et les antennes 3a et 3b émettent les deux raies d'amplitude $A_{out}/2$ déphasées par rapport à la raie d'amplitude $A_{out}$.

Dans une étape 30, les moyens de commande 14 déterminent la valeur des gains G5 et G6 du premier chemin de transmission 2 de sorte que les antennes 2a et 2b émettent ensemble un signal de référence d'amplitude $A_{out}$ correspondant au fondamental du signal $S_{out}$.

La valeur des gains G5 et G6 est identique et donnée par l'équation suivante :

$$G5 = G6 = 20 * \log\left( \frac{\frac{\sqrt{\frac{A_{out}^2}{2}}}{10^{\frac{\eta1}{20}}}}{\sqrt{\left(A_{in} * 10^{\frac{\eta1}{20}}\right)^2 + \left(A_{in} * 10^{\frac{\eta1}{20}}\right)^2}} \right) \quad (1)$$

où log est la fonction logarithme.

Puis dans une étape 31, les moyens de commande 14 déterminent la valeur des gains G25 et G26 de sorte que les antennes 3a et 3b émettent les deux raies d'amplitude $A_{out}/2$ respectivement déphasées de $+\varphi$ et $-\varphi$ par rapport au signal de référence.

Les moyens de commande 14 déterminent une différence de gain $G_{diff}$ égale à :

$$G_{diff} = G25 - G26 = 20 * \log\left(\frac{\sin(\Phi - 45°) - \tan\varphi * \cos(\Phi - 45°)}{\cos(\Phi + 45°) * \tan\varphi - \sin(\Phi + 45°)}\right) \quad (2)$$

où log est la fonction logarithme, sin est la fonction sinus et cos est la fonction cosinus, et déterminent la valeur du gain G25 :

$$G25 = 20 * \log\left(\frac{\sqrt{\frac{\frac{A_{out}^2}{2}}{\left[10^{\frac{\eta1}{10}} + 1\right]}}}{10^{\frac{\eta1}{20}}}\Big/\sqrt{\left(A_{in} * 10^{\frac{\eta1}{20}}\right)^2 + \left(A_{in} * 10^{\frac{\eta1}{20}}\right)^2}\right) \quad (3)$$

où log est la fonction logarithme.

Puis les moyens de commande déterminent la valeur de gain G26 :

$$G26 = G25 + G_{diff} \quad (4)$$

La figure 5 illustre une représentation des signaux S2a et S2b formant le signal de référence émis par les antennes 2a et 2b, et des signaux S3a et S3b émis par les antennes 3a et 3b.

Le couplage des deux entrées et sorties des premier et deuxième étages de couplage des chemins de transmission 2, 3 permettent de déphaser et amplifier les signaux émis par les antennes sans l'implémentation d'un déphaseur réduisant ainsi la consommation et l'encombrement sur le silicium des chemins de transmission, les coupleurs fonctionnant comme déphaseur, le déphasage étant piloté en ajustant les gains des étages d'amplification 4.

Selon un autre mode de réalisation du chemin de transmission 2, les moyens d'amplification de puissance à gain variable peuvent comprendre des éléments passifs, par exemple des réseaux de transistors commutables pilotés par les moyens de commande 14, configurés pour obtenir le déphasage $\varphi$ souhaité en remplacement des amplificateurs de puissance à gain variable, un réseau de transistors remplaçant un amplificateur de puissance à gain variable. Dans ce cas, les signaux émis par les antennes ne sont pas amplifiés.

La figure 6 illustre un réseau de transistors 32 comprenant trois transistors T1, T2 et T3 dont les grilles sont reliées aux moyens de commande, les drains des transistors T1 et T2 sont reliés entre eux et à une sortie du premier étage de couplage 7, la source du transistor T1 et le drain du transistor T3 sont reliés à une entrée du deuxième étage de couplage 8, et les sources des transistors T2 et T3 sont reliés à un potentiel de référence Vref choisi selon la valeur du gain du réseau 32.

Le déphasage $\varphi$ varie dans un intervalle de -35° à +35° par rapport au signal Pin.

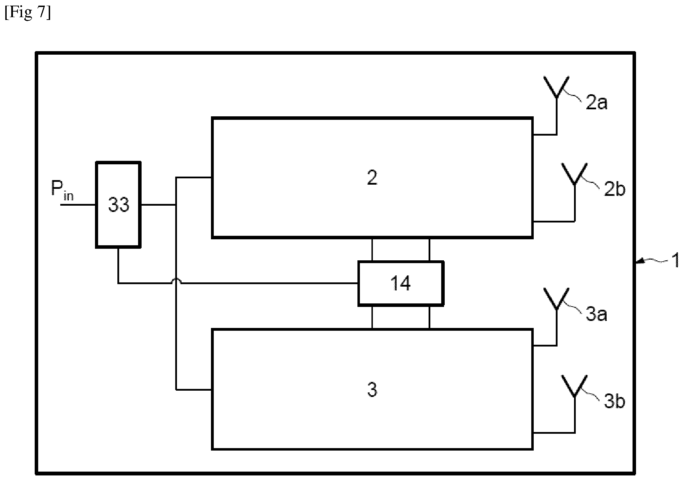

La figure 7 illustre un autre mode de réalisation du dispositif 1 permettant d'obtenir un déphasage $\varphi$ en dehors de l'intervalle de -35° à +35°.

Ce mode de réalisation diffère du mode de réalisation exposé à la figure 1 en ce que des moyens de déphasage 33 pilotés par les moyens de commande 14 sont insérés en entrée des chemins de transmission 2 et 3.

Les moyens de déphasage 33 permettent de pré-déphaser le signal Pin.

En variante, au moins une entrée du premier étage de couplage 9 comprend les moyens de déphasage 33 pilotés par les moyens de commande 14.

**Revendications**

1. Procédé de conditionnement de signaux émis par au moins deux antennes à partir d'un signal d'entrée de puissance, les deux antennes étant reliées à un chemin de transmission (2, 3) comprenant un premier étage de couplage (7) comportant un diviseur de puissance 90° et un deuxième étage de couplage (8) comportant un combineur de puissance 90°, et des moyens d'amplification de puissance à gain variable, chaque étage de couplage comportant deux entrées et deux sorties, les deux entrées du premier étage de couplage recevant ledit signal d'entrée de puissance, chaque sortie du premier étage de couplage étant reliée à une entrée différente du deuxième étage de couplage par l'intermédiaire des moyens d'amplification de puissance à gain variable, chaque sortie du deuxième étage de couplage étant reliée à une antenne différente (2a, 2b, 3a, 3b) , le procédé comprenant la détermination des gains des moyens d'amplification en fonction des caractéristiques du signal d'entrée de puissance, des caractéristiques des signaux émis par les antennes, et des caractéristiques des étages de couplage.

2. Procédé selon la revendication 1, dans lequel les caractéristiques du signal d'entrée de puissance comprennent l'amplitude et le déphasage dudit signal, et les caractéristiques des signaux émis par les antennes comprennent l'amplitude et le déphasage des signaux émis par rapport à un signal de référence.

3. Procédé selon l'une des revendications 1 et 2, dans lequel les caractéristiques des étages de couplage (7, 8) comprennent un coefficient de perte de chaque étage de couplage.

4. Procédé selon l'une des revendications 1 à 3, comprenant la détermination du déphasage des moyens de déphasage reliés à au moins une entrée du premier étage de couplage en fonction des caractéristiques du signal d'entrée de puissance, des caractéristiques des signaux émis par les antennes, et des caractéristiques des étages de couplage.

5. Procédé selon l'une des revendications 1 à 4, comprenant un premier réglage des gains identiques du premier chemin de transmission relié aux deux antennes émettant des signaux identiques formant un signal de référence et au moins un deuxième réglage des gains d'au moins un deuxième chemin de transmission relié à deux antennes émettant chacun un signal déphasé par rapport au signal de référence.

6. Dispositif électronique, comprenant au moins deux antennes destinées à émettre des signaux, et au moins un chemin de transmission (2, 3), le chemin de transmission comportant un premier étage de couplage (7) comportant un diviseur de puissance 90° et un deuxième étage de couplage (8) comportant un combineur de puissance 90°, et des moyens d'amplification de puissance à gain variable (4), chaque étage de couplage comportant deux entrées et deux sorties, les deux entrées du premier étage de couplage étant destinées à recevoir un signal d'entrée de puissance, chaque sortie du premier étage de couplage étant reliée à une entrée différente du deuxième étage de couplage par l'intermédiaire des moyens d'amplification de puissance à gain variable, chaque sortie du deuxième étage de couplage étant reliée à une antenne différente, le dispositif électronique comportant des moyens de commande (14) configurés pour piloter les gains des moyens d'amplification de puissance à gain variable en fonction des caractéristiques du signal d'entrée de puissance, des caractéristiques des signaux émis par les antennes et des caractéristiques des étages de couplage.

7. Dispositif selon la revendication 6, dans lequel les caractéristiques du signal d'entrée de puissance comprennent l'amplitude et le déphasage dudit signal, et les caractéristiques des signaux émis par les antennes comprennent l'amplitude et le déphasage des signaux émis par rapport à un signal de référence.

8. Dispositif selon l'une des revendications 6 et 7, dans lequel les caractéristiques des étages de couplage comprennent un coefficient de perte de chaque étage de couplage (7, 8).

9. Dispositif selon l'une des revendications 6 à 8, dans lequel au moins une entrée du premier étage de couplage comprend des moyens de déphasage pilotés par les moyens de commande (14).

10. Dispositif selon l'une des revendications 6 à 9, dans lequel les moyens d'amplification de puissance à gain variable comprennent deux moyens d'amplification passifs ou actifs reliant, chaque moyen reliant une sortie du premier étage de couplage à une entrée différente du deuxième étage de couplage.

11. Dispositif selon la revendication 10, dans lequel les moyens d'amplification de puissance à gain variable passifs comprennent au moins un réseau de transistors (32).

**12.** Dispositif selon la revendication 10, dans lequel les moyens d'amplification de puissance à gain variable actifs comprennent au moins un amplificateur de puissance à gain variable (4, 5, 25, 26).

**13.** Appareil de communication (AC) sans fil incorporant au moins un dispositif (1) selon l'une quelconque des revendications 6 à 12.

**Patentansprüche**

**1.** Verfahren zur Konditionierung von Signalen, die von mindestens zwei Antennen ausgehend von einem Eingangsleistungssignal gesendet werden, wobei die zwei Antennen mit einem Übertragungsweg (2, 3) verbunden sind, der eine erste Kopplungsstufe (7) umfasst, einen 90°-Leistungsteiler beinhaltend, und eine zweite Kopplungsstufe (8), einen 90°-Leistungskombinator beinhaltend, und Leistungsverstärkungsmittel mit variablem Gewinn, wobei jede Kopplungsstufe zwei Eingänge und zwei Ausgänge beinhaltet, wobei die zwei Eingänge der ersten Kopplungsstufe das Eingangsleistungssignal empfangen, wobei jeder Ausgang der ersten Kopplungsstufe mit einem anderen Eingang der zweiten Kopplungsstufe verbunden ist, mittels den Leistungsverstärkungsmitteln mit variablem Gewinn, wobei jeder Ausgang der zweiten Kopplungsstufe mit einer anderen Antenne (2a, 2b, 3a, 3b) verbunden ist, wobei das Verfahren die Bestimmung der Gewinne der Verstärkungsmittel in Abhängigkeit von den Eigenschaften des Eingangsleistungssignals, den Eigenschaften der Signale, die von den Antennen gesendet werden, und den Eigenschaften der Kopplungsstufen umfasst.

**2.** Verfahren nach Anspruch 1, wobei die Eigenschaften des Eingangsleistungssignals die Amplitude und die Phasenverschiebung des Signals umfassen, und wobei die Eigenschaften der Signale, die von den Antennen gesendet werden, die Amplitude und die Phasenverschiebung der gesendeten Signale bezüglich einem Referenzsignal umfassen.

**3.** Verfahren nach einem der Ansprüche 1 und 2, wobei die Eigenschaften der Kopplungsstufen (7, 8) einen Verlustkoeffizienten jeder Kopplungsstufe umfassen.

**4.** Verfahren nach einem der Ansprüche 1 bis 3, die Bestimmung der Phasenverschiebung der Phasenverschiebungsmittel umfassend, die mit mindestens einem Eingang der ersten Kopplungsstufe verbunden sind, in Abhängigkeit von den Eigenschaften des Eingangsleistungssignals, den Eigenschaften der Signale, die von den Antennen gesendet werden, und den Eigenschaften der Kopplungsstufen.

**5.** Verfahren nach einem der Ansprüche 1 bis 4, eine erste Einstellung der identischen Gewinne des ersten Übertragungsweges umfassend, der mit den zwei Antennen verbunden ist, die identische Signale senden, die ein Referenzsignal bilden, und mindestens eine zweite Einstellung der Gewinne von mindestens einem zweiten Übertragungsweg, der mit zwei Antennen verbunden ist, die jeweils ein Signal senden, das bezüglich dem Referenzsignal phasenverschoben ist.

**6.** Elektronische Vorrichtung, mindestens zwei Antennen umfassend, die zum Senden von Signalen bestimmt sind, und mindestens einen Übertragungsweg (2, 3), wobei der Übertragungsweg eine erste Kopplungsstufe (7) beinhaltet, die einen 90°-Leistungsteiler und eine zweite Kopplungsstufe (8) beinhaltet, die einen 90°-Leistungskombinator und Leistungsverstärkungsmittel mit variablem Gewinn (4) beinhaltet, wobei jede Kopplungsstufe zwei Eingänge und zwei Ausgänge beinhaltet, wobei die zwei Eingänge der ersten Kopplungsstufe zum Empfangen eines Eingangsleistungssignals bestimmt sind, wobei jeder Ausgang der ersten Kopplungsstufe mit einem anderen Eingang der zweiten Kopplungsstufe verbunden ist, mittels den Leistungsverstärkungsmitteln mit variablem Gewinn, wobei jeder Ausgang der zweiten Kopplungsstufe mit einer anderen Antenne verbunden ist, wobei die elektronische Vorrichtung Steuermittel (14) beinhaltet, die konfiguriert sind, um die Gewinne der Leistungsverstärkungsmittel mit variablem Gewinn in Abhängigkeit von den Eigenschaften des Eingangsleistungssignals, den Eigenschaften der Signale, die von den Antennen gesendet werden, und den Eigenschaften der Kopplungsstufen zu lenken.

**7.** Vorrichtung nach Anspruch 6, wobei die Eigenschaften des Eingangsleistungssignals die Amplitude und die Phasenverschiebung des Signals umfassen, und wobei die Eigenschaften der Signale, die von den Antennen gesendet werden, die Amplitude und die Phasenverschiebung der gesendeten Signale bezüglich einem Referenzsignal umfassen.

**8.** Vorrichtung nach einem der Ansprüche 6 und 7, wobei die Eigenschaften der Kopplungsstufen einen Verlustkoeffizienten jeder Kopplungsstufe (7, 8) umfassen.

9. Vorrichtung nach einem der Ansprüche 6 bis 8, wobei mindestens ein Eingang der ersten Kopplungsstufe Phasenverschiebungsmittel umfasst, die von den Steuermitteln (14) gelenkt werden.

10. Vorrichtung nach einem der Ansprüche 6 bis 9, wobei die Leistungsverstärkungsmittel mit variablem Gewinn zwei verbindende passive oder aktive Verstärkungsmittel umfassen, wobei jedes Mittel einen Ausgang der ersten Kopplungsstufe mit einem anderen Eingang der zweiten Kopplungsstufe verbindet.

11. Vorrichtung nach Anspruch 10, wobei die passiven Leistungsverstärkungsmittel mit variablem Gewinn mindestens ein Netzwerk von Transistoren (32) umfassen.

12. Vorrichtung nach Anspruch 10, wobei die aktiven Leistungsverstärkungsmittel mit variablem Gewinn mindestens einen Leistungsverstärker mit variablem Gewinn (4, 5, 25, 26) umfassen.

13. Drahtloses Kommunikationsgerät (AC), das mindestens eine Vorrichtung (1) nach einem der Ansprüche 6 bis 12 einschließt.

## Claims

1. A method for conditioning signals emitted by at least two antennas from a power input signal, the two antennas being connected to a transmission path (2, 3) comprising a first coupling stage (7) including a 90° power divider and a second coupling stage (8) including a 90° power combiner, and variable-gain power amplification means, each coupling stage including two inputs and two outputs, the two inputs of the first coupling stage receiving said power input signal, each output of the first coupling stage being connected to a different input of the second coupling stage via variable-gain power amplification means, each output of the second coupling stage being connected to a different antenna (2a, 2b, 3a, 3b), the method comprising determining the gains of the amplification means according to the features of the power input signal, the features of the signals emitted by the antennas, and the features of the coupling stages.

2. The method according to claim 1, wherein the features of the power input signal comprise the amplitude and the phase shift of said signal, and the features of the signals emitted by the antennas comprise the amplitude and the phase shift of the emitted signals with respect to a reference signal.

3. The method according to one of claims 1 and 2, wherein the features of the coupling stages (7, 8) comprise a loss coefficient of each coupling stage.

4. The method according to one of claims 1 to 3, comprising determining the phase shift of the phase-shifting means connected to at least one input of the first coupling stage according to the features of the power input signal, the features of the signals emitted by the antennas, and the features of the coupling stages.

5. The method according to one of claims 1 to 4, comprising a first adjustment of the identical gains of the first transmission path connected to the two antennas emitting identical signals forming a reference signal and at least a second adjustment of the gains of at least a second transmission path connected to two antennas each emitting a phase-shifted signal with respect to the reference signal.

6. An electronic device, comprising at least two antennas intended to emit signals, and at least one transmission path (2, 3), the transmission path including a first coupling stage (7) including a 90° power divider and a second coupling stage (8) including a 90° power combiner, and variable-gain power amplification means (4), each coupling stage including two inputs and two outputs, the two inputs of the first coupling stage being intended to receive a power input signal, each output of the first coupling stage being connected to a different input of the second coupling stage via variable-gain power amplification means, each output of the second coupling stage being connected to a different antenna, the electronic device including control means (14) configured to control the gains of the variable-gain power amplification means according to the features of the power input signal, the features of the signals emitted by the antennas and the features of the coupling stages.

7. The device according to claim 6, wherein the features of the power input signal comprise the amplitude and the phase shift of said signal, and the features of the signals emitted by the antennas comprise the amplitude and the phase shift of the emitted signals with respect to a reference signal.

8. The device according to one of claims 6 and 7, wherein the features of the coupling stages comprise a loss coefficient of each coupling stage (7, 8).

9. The device according to one of claims 6 to 8, wherein at least one input of the first coupling stage comprises phase-shifting means controlled by the control means (14).

10. The device according to one of claims 6 to 9, wherein the variable-gain power amplification means comprise two passive or active amplification means connecting, each means connecting an output of the first coupling stage to a different input of the second coupling stage.

11. The device according to claim 10, wherein the passive variable-gain power amplification means comprise at least one array of transistors (32).

12. The device according to claim 10, wherein the active variable-gain power amplification means comprise at least one variable-gain power amplifier (4, 5, 25, 26).

13. A wireless communication apparatus (AC) incorporating at least one device (1) according to any one of claims 6 to 12.

[Fig 1]

[Fig 2]

[Fig 3]

[Fig 4]

[Fig 5]

[Fig 6]

[Fig 7]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016164466 A1
- EP 2456090 A1